# FASCICULE DE BREVET EUROPEEN

(11) **EP 0 658 276 B1**
(45) Date de publication et mention de la délivrance du brevet: **23.08.2006**
(21) Numéro de dépôt: 94916362.0
(22) Date de dépôt: 07.06.1994
(51) Int. Cl.: H01L 31/032, H01L 31/18, H01L 21/368

(54) **PROCEDE POUR FORMER UN COMPOSE CuInSe2**
HERSTELLUNGSVERFAHREN FÜR EINE CuInSe2-VERBINDUNG
METHOD FOR PREPARING A CuInSe2 COMPOUND

(30) Priorité: 08.06.1993 CH 172293
(43) Date de publication de la demande: 21.06.1995
(73) Titulaire: YAZAKI CORPORATION, Minato-ku Tokyo 108 (JP)
(72) Inventeur: GREMION, François, CH-1252 Meinier (CH); ISSARTEL, Jean-Paul, F-74380 Cranves-Sales (FR); MUELLER, Klaus, CH-1212 Grand-Lancy (CH)
(74) Mandataire: Savoye, Jean-Paul
(86) Numéro de dépôt international: PCT/IB1994/000147
(87) Numéro de publication internationale: WO 1994/029904

(56) Documents cités:
- WO-A-92/05586
- FR-A- 2 668 299
- THIN SOLID FILMS vol. 195, no. 1/2 , Janvier 1991 , LAUSANNE CH pages 137 - 146 C. GUILL¹N ET AL. 'Cathodic electrodeposition of CuInSe2 thin films'
- JOURNAL OF PHYSICS D. APPLIED PHYSICS vol. 19, no. 7 , Juillet 1986 , LONDON GB pages 1299 - 1309 R.P. SINGH ET AL. 'Electrodeposited semiconducting CuInSe2 films: I. Preparation, structural and electrical characterisation'
- SOLAR ENERGY MATERIALS vol. 26, no. 1/2 , Mars 1992 , AMSTERDAM NL pages 149 - 158 S.R. KUMAR ET AL. 'Preparation and properties of a Cu-In alloy precursor for CuInSe2 films'
- SOLAR CELLS. vol. 16, no. 1/4 , Janvier 1986 , LAUSANNE CH pages 245 - 254 G. HODES ET AL. 'Electrodeposition of CuInSe2 and CuInS2 films'
- SOLAR ENERGY MATERIALS vol. 20, no. 1/2 , Janvier 1990 , AMSTERDAM NL pages 53 - 65 J. HERRERO ET AL. 'Electrodeposition of Cu-In alloys for preparing CuInS2 thin films'

## Description

La présente invention se rapporte à un procédé pour former un composé CuInSe₂ (CIS) par dépôt d'un précurseur de ce composé par voie au moins en partie électrolytique sur un substrat et formation du composé CuInSe₂ par réaction thermique.

On a déjà proposé dans le DE-C2-4103291 un procédé de fabrication de couches minces CuInSe₂ par dépôt galvanique d'une couche Cu/In contenant du Se dispersé sous forme de particules dans un rapport stoechiométrique, suivi d'un traitement thermique pour former le composé CuInSe₂ jouant le rôle de couche semi-conductrice photosensible qui, une fois recouverte d'une couche de CdS par exemple, constitue une diode génératrice d'un effet photovoltaïque.

Le dépôt par voie électrolytique, en particulier de l'In, répond à une exigence économique. Il est en effet indispensable que le rapport prix/rendement photovoltaïque soit compétitif avec les autres modes de production d'énergie électrique. C'est la raison pour laquelle les procédés de dépôt de tous les composants en phase vapeur qui ont déjà été proposés sont beaucoup trop coûteux pour produire des capteurs solaires à prix compétitifs. En effet, le dépôt d'In en phase vapeur engendre une condensation d'In sur les parois de l'enceinte. La quantité d'In ainsi perdue est importante. Or, l'In est un métal cher.

Non seulement le dépôt par voie électrolytique présente la difficulté de déposer simultanément les trois éléments Cu In Se, mais encore, compte tenu de l'extrème réactivité du Se, il s'avère que l'un des rares substrats plus ou moins susceptible de résister au Se au moment de la formation du composé CIS est le Mo. Tous les spécialistes de l'électrochimie savent que le molybdène constitue un substrat sur lequel il est difficile de déposer des métaux ou alliages avec une excellente adhérence par voie galvanique. C'est ainsi que le cuivre ne se dépose que relativement difficilement sur le molybdène par cette voie et l'alliage In-Cu a une très faible adhérence. De plus, le molybdène adhère très mal sur le verre qui constitue généralement le support le plus utilisé pour les capteurs photo-voltaïques.

On peut donc constater que si le problème du dépôt conjoint Cu In Se a trouvé une solution, il reste bien d'autres problèmes à résoudre pour permettre la production de capteurs photovoltaïques à couche de CuInSe₂ (appelée par la suite CIS) obtenue au moins partiellement par dépôt galvanique.

Le but de la présente invention est précisément d'apporter une solution au problème du dépôt au moins partiellement par voie galvanique d'un composite qui sert de précurseur au CIS sur un substrat de Mo.

A cet effet, cette invention a pour objet un procédé pour former un composé CuInSe₂ par dépôt d'un précurseur de ce composé par voie au moins en partie électrolytique sur un substrat et formation du composé CuInSe₂ par réaction thermique selon la revendication 1.

Un des avantages de la solution proposée est d'augmenter l'adhérence de la couche de CuInSe₂ sur le substrat conducteur en diminuant, par la même occasion, la porosité à l'interface. En fait, cette diminution de la porosité est au moins en partie la cause de la meilleure adhérence de la couche de CIS.

Le dépôt plus ou moins séparé de Cu et d'In, en commençant par l'un ou l'autre de ces éléments, par voie galvanique ou par PVD, ou par PVD suivi de dépôt galvanique, avec incorporation de Se sous forme de particules dans au moins une des couches de Cu ou d'In, permet d'obtenir un précurseur qui se prête bien à la transformation en CIS en conservant une bonne adhérence sur le substrat. On sait qu'une importante augmentation de volume de la couche In/Cu se produit lors de la sélénisation en vue de la formation du composé CuInSe₂. On a constaté que l'incorporation d'une certaine proportion de Se sous forme de particules dans au moins une des couches soit à majorité ou à totalité d'In soit à majorité ou à totalité de Cu permet de réduire l'importance de cette augmentation de volume et par là même le risque de délaminage de la couche CIS.

En plus du problème de l'adhérence, le fait de déposer les éléments Cu et In séparément présente un avantage du point de vue électrochimique. Le dépôt d'In est accompagné d'un dégagement d'hydrogène qui est encore favorisé par la présence de particules de Se. Dès lors, ce phénomène rend le dépôt conjoint de Cu et d'In très difficile, surtout parce que le dégagement d'hydrogène n'est pas constant, de sorte qu'il devient extrêmement difficile, voire impossible, de maintenir un rapport Cu/In constant dans ces conditions.

Il existe deux moyens pour obtenir une couche comprenant > 50 % At de In, l'un en déposant de l'In dans un électrolyte d'indium ce qui donne une couche 100 % In, l'autre en déposant une couche entre 50 et 100 % At d'indium à partir d'un bain contenant, soit un mélange Cu/In dans un rapport atomique entre 1:3 et 1:50, soit un même mélange auquel on ajoute une certaine quantité de particules sèches de Se et dans lequel on travaille à une densité de courant relativement élevée. Sur cette base, on peut obtenir une double couche du précurseur de CIS par dépôts successifs d'une première couche riche en In (≤ 100 % At) et d'une seconde couche riche en Cu (≤ 100 % At). Pour obtenir la première couche entre 50 et 100 % At d'indium, on augmente la densité de courant au-dessus de 3,5 A/dm². Pour obtenir la seconde couche on diminue ensuite la densité de courant en faisant en sorte que la proportion atomique globale Cu/In des deux couches soit par exemple 50/50 pour la formation d'un alliage 1:1 de Cu et In, ou 25/25 dans le cas où on dépose simultanément 50 % At de sélénium sous forme de particules dispersées dans le bain Cu/In pour obtenir la couche précurseur du CIS.

L'apport de Se à la couche Cu/In peut être obtenu de différentes manières. On peut incorporer par dépôt conjoint, pendant le dépôt galvanique des métaux, soit la quantité stoéchiométrique ou sous-stoéchiométrique de Se₂ au Cu/In en dispersant des particules de Se dans le ou les bains Cu/In. On peut également envisager d'apporter soit la totalité de Se, soit un complément sous forme de vapeur de Se amenée ou produite dans un réacteur, sous forme d'une couche séparée, déposée sur la couche Cu/In par sérigraphie ou par tout autre procédé d'impression approprié tel que tampographie ou encore par une combinaison de ces deux procédés.

Pour améliorer l'adhérence de la couche de Mo sur la lame de verre, on peut déposer une sous-couche de chrome de 0,2 µm par exemple, par PVD puis la couche de molybdène par la même technique. Il faut toutefois préciser que cette couche de Cr n'est pas indispensable et sa fonction peut être remplacée par une étape de décapage par bombardement ionique du substrat de verre avant le dépôt du Mo par PVD. Toutefois, la différence de coefficients de dilatation thermique entre le verre et le molybdène et les contraintes mécaniques qui sont inhérentes à la morphologie des couches PVD nécessitent d'optimiser les paramètres de dépôt (température du substrat, pression d'argon, pression partielle d'oxygène, vitesse de dépôt) et le processus de relaxation, ainsi que l'épaisseur de la couche de Mo. Lors du traitement thermique pour la formation du composé CIS, dont la température culmine à 400-450°C, il n'y a pas de risque de réaction entre le Cr et le Mo à cette température.

Comme on l'a déjà mentionné, le dépôt électrolytique de Cu sur du Mo est difficile à réaliser. Etant donné que le Mo est déposé par PVD sur le verre ou une sous-couche de Cr, comme on l'a déjà indiqué, il est possible, au cours de la même opération de dépôt, de former une couche de Cu sur le Mo. Cette couche de Cu peut être extrêmement mince, de préférence ≤ 0,2 µm. Dans une variante il est aussi possible de déposer par PVD toute la quantité de Cu nécessaire pour la couche précurseur du CIS. Le revêtement de Cu sur Mo permet de protéger la surface de Mo pendant le stockage du substrat.

A la place du Mo formant le substrat pour la couche CIS, on peut envisager d'utiliser le TiN ou le ZrN tous deux également déposés par PVD voire par CVD. Etant donné la plus faible conductivité électrique du TiN et du ZrN par rapport au Mo, il est préférable au cours de la même opération de revêtement par PVD de déposer au moins une fine couche < 1 µm de Cu avant de passer au dépôt galvanique représentant soit la totalité soit une partie du cuivre nécessaire pour le précurseur du CIS. La couche de Cu permet d'améliorer la conductivité électrique du substrat en vue du dépôt galvanique ultérieur.

Tous les exemples qui vont suivre ont été préparés à partir de lames de verre à vitre ordinaire soda-calcique, fourni pré-nettoyé par le fabricant (Menzel Glas, Allemagne), et constituant le support du substrat de Mo, de TiN ou de ZrN.

Ce verre a été tout d'abord soumis à un décapage chimique dans une solution aqueuse d'acide fluorhydrique à 10 % à température ambiante pendant 3 minutes environ. Ce décapage chimique a été suivi d'un décapage ionique dans un plasma basse pression à l'argon, voire à l'argon plus oxygène.

Après le décapage ionique, le support de substrat en verre est disposé en face d'une cathode à magnétron équipée d'une cible en chrome 99,8 (de Cerac, Milwaukee, USA). La distance cible-substrat est de 50 mm. L'enceinte de pulvérisation, qui est à une pression de 0,4 Pa, est alimentée en argon à un débit de 40 cm³/min et le magnétron est alimenté en courant basse intensité (typiquement 2 A/dm²). On dépose une couche de chrome d'accrochage de 0,2 µm à une vitesse de 4,8 nm/s.

Ensuite, le support du substrat est tourné en face d'une seconde cathode à magnétron, équipée d'une cible en molybdène 99,9 (de Plansee, Reutte, Autriche), la distance cible-substrat est de 55 mm. L'enceinte de pulvérisation est à une pression de 0,3 Pa et est alimentée par un débit d'argon de 30 cm³/min. Une couche de 2 µm de molybdène est déposée sur la couche d'accrochage de chrome à une vitesse de 6,5 nm/s.

Comme on l'a mentionné précédemment, on peut déposer une couche de Cu sur le Mo ou le TiN par PVD. A cet effet, le substrat verre/Cr/Mo est placé en face d'une cathode au magnétron équipée d'une cible en 99,99 % Cu (de Cerac, Milwaukee, USA). La distance cible-substrat est de 70 mm. L'enceinte de pulvérisation est à une pression de 0,3 Pa et est alimentée par un débit d'argon de 30 cm³/min. La vitesse de dépôt est de 3 nm/s et l'épaisseur du dépôt est de 0,1 à 0,2 µm. Il s'agit dans cet exemple de ne déposer qu'une couche d'accrochage pour le dépôt galvanique ultérieur. Si on désire faire un dépôt plus épais correspondant par exemple à la totalité du cuivre à déposer pour la couche CIS, on peut augmenter la vitesse de dépôt à 15 nm/s.

On pourrait également déposer de l'In par PVD, bien que, comme on l'a dit, le métal étant cher, une proportion importante est perdue par ce procédé.

A cet effet, on place le substrat verre/Cr/Mo au-dessus d'une nacelle en molybdène (de Balzers AG, Liechtenstein) contenant des morceaux de 99,999 % In (aussi de Balzers). La pression de dépôt est < 10⁻³Pa. La nacelle est chauffée par effet Joule à la température d'évaporation de l'In. La vitesse de dépôt est de 10 nm/s.

Comme on l'a dit, on peut déposer du TiN sur un substrat de verre. Après décapage ionique de ce substrat, le support de substrat en verre est disposé en face d'une cathode au magnétron équipée d'une cible en 99,9 % Ti (de Cerac, Milwaukee, USA). La distance cible-substrat est de 50 mm. L'enceinte de pulvérisation est à une pression de 0,4 Pa sous un débit de gaz contenant un mélange d'argon et d'azote très purs (N48). Cette pulvérisation réactive permet de déposer une couche de nitrure de titane à une vitesse de 1 à 2 nm/s. Sur cette couche d'environ 1,2 µm est déposée immédiatement après au cours du même processus de dépôt et dans les conditions opératoires indiquées précédemment une couche de Cu dont l'adhérence sur le TiN est excellente, qui permet le dépôt galvanique du précurseur du composé CIS.

Le sélénium en poudre utilisé pour être mélangé au bain galvanique est, soit une poudre de Noranda, Canada, vendue sous la dénomination 5N et sa granulométrie mesurée sur les échantillons, va de 1,96 à 2,72 µm avec une dispersion allant de 0,84 µm à 1,07 µm, respectivement, soit une poudre de Retorte (Allemagne) avec des caractéristiques proches de celles du produit de Noranda. Cette poudre est hydrophobe, de sorte qu'elle se disperse mal dans les bains électrolytiques de dépôt In-Cu. Pour résoudre ce problème, on a préparé une dispersion solide dans liquide dans une bouteille de polyéthylène de 250 ml dans laquelle on a mis 200 g de billes de Si₃N₄ de 5 mm de diamètre, 18 g de poudre de sélénium (Noranda), 100 ml de bain de dépôt galvanique In-Cu de pH 1,4 et 1 ml de surfactant liquide Fluorad FC 171 (3M). Ce mélange a été broyé pendant 24 à 48 h, après quoi la poudre de Se est devenue mouillable et le mélange initial prend une consistance pâteuse. Ce broyage a une faible répercussion sur la granulométrie qui va, après broyage, de 1,64 µm à 1,83 µm avec une dispersion de 0,83 µm.

Selon un autre procédé d'incorporation de la poudre de Se au bain électrolytique qui permet en même temps de réduire sensiblement la taille des particules, on met en rotation pendant 20 heures le même flacon de polyéthylène de 250 ml contenant 200 g de billes céramique, par exemple de Si₃N₄, 10 g de poudre de Se (de Retorte , Allemagne) et 20 g de tartrate double de sodium et de potassium (sel de seignette, Siegfried No 16.33.00.04). On ajoute ensuite 180 ml d'eau et 0,14 g de dispersant Triton X-100® et l'on fait encore tourner le flacon pendant 12 heures. D'autres sels, tels que le sulfate de sodium ou le citrate de potassium, ont donné des résultats similaires dans ce procédé de broyage partiellement à sec.

On obtient alors une poudre finement broyée dont la taille moyenne des grains est de 0,74 µm avec une dispersion de 0,54 µm. Cette diminution de la taille des particules de Se est très importante dans la mesure où elle permet de réduire l'épaisseur de la couche contenant ces grains.

Selon une autre variante, le broyage est réalisé en mettant en rotation pendant 1 h 30 mn un flacon de polyéthylène de 1 1 contenant 1017 g de billes de Si₃N₄, 50 g de poudre de Se et 100 g d'acide citrique monohydraté. On ajoute ensuite 303 g d'eau déminéralisée et 0,50 g de dispersant Triton X-100® . On remet le flacon en rotation durant 46 heures. La taille moyenne des grains de poudre est de 0, 88 µm avec une dispersion de 0,74 µm. Selon encore une autre variante, le broyage est réalisé dans un broyeur double-cône CoBall Mill (de Fryma Rheinfelden, Suisse) avec des billes de céramique d'un diamètre < 1 mm en phase liquide contenant un dispersant et avec des vitesses du rotor de l'ordre de 15 m/s. Ce broyage donne des particules de taille sensiblement inférieure à 1 µm.

Il faut toutefois préciser que la présente invention n'est pas limitée au dépôt stoechiométrique de Cu, In, Se₂ dans un bain ou deux bains. En effet, comme on le verra par la suite, de préférence, le Se peut être amené, au moins en partie, sous d'autres formes. Avant tout, le but de l'invention est le dépôt électrolytique Cu-In sur un substrat conducteur électrique susceptible d'offrir une résistance au Se en phase vapeur. Ce dépôt est possible de plusieurs manières, comme on l'illustrera dans les exemples qui vont suivre.

On a utilisé pour ces exemples une cellule de dépôt électrolytique de 210 x 55 x 60 mm remplie avec 500 ml d'électrolyte.

La poudre de Se dispersée dans le bain, peut engendrer suivant sa concentration, une phase mousseuse recouvrant une phase liquide, ou une seule phase liquide uniformément dispersée.

### Exemple 1

On prend un substrat de molybdène sur la lame de verre de 15 x 15 mm préparé comme décrit précédemment. On le décape par une attaque basique. On prépare un bain alcalin pH 9-11 avec du sulfate d'indium à 0,2 mol/l, on plonge le substrat en lui donnant un potentiel cathodique et en le plaçant à 20 cm de l'anode en Pt inerte. La densité de courant est de 2 A/dm² et l'épaisseur du dépôt est de 0,2 µm.

On rince soigneusement ce revêtement d'In à l'eau déminéralisée et on le plonge ensuite dans un second bain acide pH 1,3 contenant du sulfate de cuivre et du sulfate d'indium dans un rapport atomique Cu/In de 1:20. On ajuste la densité de courant à < 1,1 A/dm² pour que les proportions atomiques totales de la première couche d'indium et de la seconde couche d'alliage CuIn de 3 µm d'épaisseur soit sensiblement 50/50. En effet, plus la densité de courant diminue, plus la proportion de Cu dans le dépôt augmente et inversement.

Le sélénium peut être apporté séparément, soit par sérigraphie, soit par tampographie, soit directement dans le réacteur au moment de la réaction thermique destinée à former le composé CuInSe₂, comme on le verra par la suite, soit encore par combinaison de ces trois moyens.

### Exemple 2

On prend un bain acide pH 1,3 de sulfamate de cuivre et de sulfamate d'indium dans un rapport atomique de 1:20 Cu 0,01 mole/l, In 0,2 mole/l, dans lequel on plonge l'échantillon présentant le substrat de molybdène, obtenu comme décrit précédemment, comme cathode à une distance de 20 cm de l'anode en Pt inerte. Dans un premier temps, on porte la densité de courant à 4 A/dm² pour former une première couche d'au moins 0,2 µm contenant > 95 % In. Ensuite, on abaisse la densité de courant à < 1,1 A/dm² pour que l'épaisseur totale des deux couches de l'ordre de 2 µm présente un rapport atomique Cu/In sensiblement égal à 50/50. Les concentrations globales de Cu et d'In dans les deux couches sont déterminées par dissolution dans l'acide nitrique concentré et analysé par AES-ICP (spectroscopie à émission atomique par plasma produit par induction).

### Exemple 3

Même bain que dans l'exemple 2, mais avec un rapport atomique Cu/In 1:25 auquel on ajoute 200 g/l de poudre de Se et 0,3 g/l de surfactant liquide Fluorad FC 171 (3M). Anode en Pt inerte.

On plonge l'échantillon porteur du substrat de Mo dans la phase mousseuse du bain à une distance de 20 cm de l'anode et on crée une circulation du liquide du bain de 4 l/min que l'on déverse sur un plan incliné disposé au-dessus du bain de manière à former un rideau de liquide qui irrigue la surface du substrat. La densité du courant est de 4 A/dm². Après 30 s, on a formé une première couche dont la composition atomique est d'environ 60 % In, 30 % Cu et 10 % Se.

On arrête alors d'irriguer la surface du substrat sans arrêter la recirculation du liquide du bain et on déplace la cathode (substrat) selon un mouvement alternatif dans son plan horizontalement, donc parallèlement à l'anode, avec une amplitude de mouvement de 3 cm et une durée de la période de 2 s. La durée du dépôt est de 3 min et l'épaisseur de la seconde couche est de l'ordre de 10 µm. La composition atomique de cette couche est de l'ordre de 25 % pour le Cu, 15 % pour l'In et 60 % pour le Se.

Dans cet exemple, la différence entre les compositions atomiques de la première couche et de la seconde couche ne provient donc que de facteurs cinétiques entre le bain et le substrat, les paramètres électriques restant constants. On a constaté que la première couche contenant > 50 % At d'In permet d'assurer une adhérence suffisante sur le substrat de Mo.

### Exemple 4

Même bain que pour l'exemple 3. Anode en Pt inerte.

Dans cet exemple, l'échantillon (cathode) est disposé à 20 cm de l'anode et ne bouge pas tout au long du processus de dépôt.

On commence le dépôt avec une densité de courant de 6 A/dm² pendant 1 min, après quoi elle est abaissée à 1,56 A/dm² pendant 5 min. Une observation au microscope électronique montre une couche de l'ordre de 8 µm d'épaisseur avec une première couche moins poreuse, plus riche en In ce qui facilite l'adhérence sur le Mo, que lors du dépôt sans la première couche à la surface du substrat.

Il est apparu par ailleurs que la dispersion de Se dans le bain Cu-In provoque un changement du rapport Cu-In déposé. A partir d'un bain déterminé, plus on y disperse de Se, moins il y a d'In dans la couche déposée, d'où la solution adoptée selon l'exemple 3, qui constitue une alternative pour obtenir une première couche riche en In.

### Exemple 5

On prend un bain acide pH 1,3 de sulfamate de cuivre et de sulfamate d'indium dans un rapport atomique de 1:20 Cu 0,01 mole/l, In 0,2 mole/l, dans lequel on plonge l'échantillon présentant le substrat de molybdène, obtenu comme décrit précédemment, comme cathode à une distance de 20 cm de l'anode en Pt inerte. Dans un premier temps, on porte la densité de courant à 4 A/dm² pour former une première couche d'au moins 0,2 µm contenant > 95 % In. Ensuite, on abaisse la densité de courant à < 1,1 A/dm² pour que l'épaisseur totale des deux couches de l'ordre de 2 µm présente un rapport atomique Cu/In sensiblement égal à 50/50.

Ensuite, on prépare une pâte de sérigraphie en mélangeant de la poudre de sélénium (ayant une taille moyenne de particule voisine de 1 micron) avec un liant et un solvant :

| | |
|---|---|
| 80 g | terpineol (solvant) |
| 7,8 g | éthylcellulose (liant) |
| 26 g | poudre de sélénium |

Cette pâte est ensuite sérigraphiée sur la surface de la couche de Cu/In précédemment préparée en utilisant un écran de sérigraphie muni d'une toile en polyester (ZBF, Monolen 130 T). La distance entre la face inférieure de l'écran et la couche de Cu/In est ajustée à 2 mm et la vitesse de la racle sur l'écran est réglée à 5 cm/sec. La couche de sélénium ainsi sérigraphiée est ensuite séchée pendant 2 heures à 40°C. Dans ces conditions, l'opération de sérigraphie produit une couche régulière d'épaisseur de l'ordre de 3-6 µm après séchage. Les produits organiques utilisés dans la préparation de la pâte de sérigraphie (liants) sont ensuite éliminés sans laisser de résidu lors d'un traitement thermique à température modérée (400°C durant 1 heure).

Pour obtenir la couche du composé CuInSe₂, on procède ensuite au traitement thermique qui sera décrit par la suite.

### Exemple 6

La préparation de la poudre de Se de cet exemple commence par un broyage à sec qui consiste à introduire dans un flacon de 1 litre en PE, 40 g de Se (de Retorte , Allemagne) sec, 80 g de sel double Na + K de l'acide tartrique (sel de seignette) Siegfried, N° 16.33.00.04, ou certains autres sels de Na ou K et 800 g de billes de Si₃N₄. On fait tourner le flacon à 100 t/min pendant 15 heures puis on ajoute 282 g d'eau et 0,4 g de Triton X-100® . On continue le broyage en milieu liquide à la même vitesse durant 6 h 30 min.

On complète la quantité d'eau jusqu'à 1 litre et on tente une première sédimentation. Le surnageant est encore un peu trouble. On transvase dans un flacon de 2 litres que l'on complète avec de l'eau et on laisse sédimenter durant 40 heures 45 min. On enlève 1500 g d'eau. Il reste ≈ 0,4 litre de billes + Se. On ajoute = 0,6 litre de solution : 0,10 mol d'In + 0,5 mol de Na₂SO₄ et on ajoute un dispersant, ici, 0,4 g de Triton X-100® . On remet à broyer pendant 27 heures, on sépare les billes avec un tamis, on complète avec de l'eau jusqu'à 3 litres et on agite avec un agitateur magnétique pour maintenir le Se en suspension.

Dans cet exemple, il s'agit de déposer par voie électrolytique de l'In avec des particules de Se sur une couche de Cu seul, déposée soit par PVD, comme décrit précédemment, soit par PVD suivi d'un revêtement galvanique de Cu pur.

A cet effet, on prend un bain acide pH 2 de sulfate d'In, 0,10 mol d'In, dans lequel on a incorporé 13 g/l de Se.

Le bain ainsi préparé est placé dans une cuve à deux compartiments, il est mis en circulation par une pompe et se déverse d'un compartiment dans l'autre par débordement. Il est régulé en température et agité à l'aide de barreaux magnétiques. Le dépôt s'effectue dans le second compartiment alors que le contenu du premier compartiment est soumis aux ultrasons. On plonge le substrat verre + Mo ou verre + Mo + Cu (déposé par PVD), comme cathode, à une distance de 14 cm de l'anode en Pt inerte. On applique une densité de courant de 3 A/dm² et on obtient ainsi une couche d'In contenant 5 à 20 % At de Se.

### Exemple 7

Il s'agit d'un exemple identique à l'exemple 6, mais dans lequel le substrat de verre + Mo + Cu est remplacé par un substrat de verre + TiN + Cu déposés par PVD. La couche du précurseur de CIS déposé par voie galvanique comporte 30 % à 50 % At de Se en poudre.

### Exemple 8

Dans cet exemple, on revêt un substrat verre + Mo + Cu + In déposés par PVD (ou éventuellement Cu par PVD et In par voie galvanique) avec un dépôt galvanique de Cu avec de la poudre de Se. Les quantités de Cu et In déposées par PVD sont nettement sous-stoechiométriques.

On prend un bain acide pH 1 de sulfate de Cu préparé dans un flacon de PE de 2 litres dans lequel on met 120 g CuSO₄ + 77 g d'acide citrique + 74 g H₂SO₄ (= 271 g), 0,13 g de Triton X-100® , 13 g Se sec (de Retorte, Allemagne) et 260 g de billes Si₃N₄.

On met à tourner à 100 t/min pendant 87,5 heures. On sépare les billes au tamis, on prélève une faible quantité et on rince avec de l'eau pour compléter à 1 litre.

Le bain est placé dans la même cuve que pour l'exemple 6. On plonge le substrat verre/Mo/Cu/In comme cathode à une distance de 14 cm de l'anode en Pt inerte et on effectue le revêtement. L'analyse EDX montre une incorporation de particules de Se dans une proportion At de 4 %.

### Exemple 9

On prend un bain acide pH 1,3 comprenant du Cu/In sous forme de sulfamate dans un rapport atomique 1:20 avec 200 g/l de Se en poudre, incorporé par broyage avec billes de Si₃N₄ dans l'électrolyte comme indiqué précédemment. On obtient un bain à deux phases, liquide et mousseuse, respectivement pauvre et riche en particules de Se.

Le revêtement du substrat verre/Cr/Mo constituant la cathode s'obtient en agitant faiblement la cathode dans la phase mousseuse riche en Se. Cette agitation consiste à déplacer alternativement la cathode parallèlement à l'anode en Pt inerte et, au niveau du bain d'électrolyte, avec une amplitude de quelques cm. La densité de courant est de 9,3 mA/cm² et la durée de dépôt est de 25 min.

Dans ce dépôt qui constitue une des deux couches du précurseur de CIS, l'analyse par spectrométrie X par sélection d'énergie (EDX) donne 2,28 % Cu, 97,32 % Se.

### Exemple 10

On prend un bain acide pH 1,3 comprenant du Cu/In sous forme de sulfamate dans un rapport atomique 1:6 avec 200 g/l de Se, incorporé dans l'électrolyte par broyage à l'aide de billes de Si₃N₄. On obtient deux phases, l'une liquide, pauvre en Se, et l'autre mousseuse, riche en Se. On soumet le substrat verre/Cr/Mo constituant la cathode à un mouvement alternatif de quelques cm d'amplitude, parallèlement à l'anode et verticalement. On applique une densité de courant de 2,89 A/dm² pendant 3 min.

Dans cet exemple qui représente l'une des deux couches du précurseur de CIS, l'analyse par spectrométrie X par sélection d'énergie (EDX) donne 55,5 % Cu, 15,7 % In, 28,8 % Se.

On peut aussi produire des particules colloïdales de Se, on réduit l'acide sélénique avec de l'hydrazine (catalysé par l'acide).

On produit le Se dans un milieu tel que l'eau ou l'acide, avec moins de succès en milieu alcalin. La formation de colloïde est visible par un net changement de couleur de la solution vers le rouge et peut être testée par l'effet Tyndall. Suivant la concentration d'acide sélénique et d'hydrazine, la réaction peut être relativement lente et est par conséquent bien contrôlable (par exemple dans une solution de 1mM de Se^{IV}, le Se colloïdal devient visible après 30 minutes). Une température de 30°-45°C provoque une certaine accélération de la réaction. Un stabilisant tel que la gélatine semble être nécessaire pour éviter la précipitation du colloïde par coagulation et aggrégation des particules. Une telle solution colloïdale est ajoutée au bain galvanique de Cu ou In pour produire des dépôts composites de ces métaux avec particules de Se incorporées. L'avantage de cette solution est de pouvoir introduire des particules de Se encore plus fines et de réduire ainsi l'épaisseur de la couche de CIS.

Le traitement thermique de sélénisation destiné à former le composé CIS par réaction entre les éléments du précurseur déposé est réalisé en plaçant les échantillons verticalement dans un creuset en graphite chauffé par induction. Ce traitement est effectué sous un vide de l'ordre de 10⁻² Pa. L'atmosphère au voisinage des échantillons est enrichie en vapeur de Se engendrée par l'évaporation de granulés de Se de 0,3-3 mm placés au-dessous des échantillons. La pression partielle de sélénium est ajustée par la température utilisée pendant la sélénisation.

Le cycle de sélénisation s'effectue en introduisant au fond du creuset 0,2 g de granulés de sélénium, puis en chauffant le creuset découvert à 15°C/min jusqu'à 104° et en maintenant un palier à cette température pendant 5 min pour assurer un séchage complet des échantillons. On abaisse ensuite le couvercle du creuset en graphite et on chauffe le creuset à 15°C/min jusqu'à 400°C qui est la température de sélénisation. Cette température est maintenue pendant 1 heure. Le chauffage est ensuite arrêté et on laisse refroidir à la température ambiante pendant 1,5 heure.

Selon un autre exemple, le cycle de sélénisation est effectué en introduisant 0,1 g de granulés de Se dans le creuset ainsi que les échantillons. On chauffe le creuset à 15°C/min jusqu'à 108°C et en maintenant un palier à cette température pendant 5 min pour sécher les échantillons. Le couvercle en graphite est ensuite abaissé sur le creuset et on le chauffe à 15°C/min jusqu'à 450°C. Cette température est maintenue pendant 1 heure puis le refroidissement se déroule comme précédemment.

## Revendications

1. Procédé pour former un composé CuInSe₂ par dépôt d'un précurseur de ce composé par voie au moins en partie électrolytique sur un substrat et formation du composé CuInSe₂ par réaction thermique, **caractérisé par le fait que** l'on choisit un substrat conducteur électrique susceptible de résister à la réactivité du Se en phase vapeur, sur lequel on dépose une première couche comprenant entre > 50 % et 100 % At soit d'In, soit du Cu, le reste étant au moins en partie soit du Cu, respectivement, soit de l'In, puis une seconde couche de composition entre > 50 % et 100 % At soit de Cu, respectivement, soit d'In, afin de ramener le rapport At In/Cu de l'ensemble des deux couches sensiblement à 1/1, que l'on met entre 4 % et 100 % At de la couche totale In/Cu de Se sous forme de particules solides en contact avec l'une au moins de ces couches et que l'on forme le composé par réaction thermique en amenant, si besoin, la proportion de Se à 100 % At de la couche In/Cu en effectuant cette réaction thermique dans une atmosphère neutre amenée à la pression de vapeur du Se.

2. Procédé selon la revendication 1, **caractérisé par le fait que** le Se est incorporé à ladite seconde couche sous forme de particules mélangées au bain électrolytique In/Cu.

3. Procédé selon la revendication 1, **caractérisé par le fait que** le Se est déposé par un procédé d'impression sur ladite couche In/Cu.

4. Procédé selon la revendication 1, **caractérisé par le fait que** l'on forme ladite première couche et ladite seconde couche à l'aide d'un même bain galvanique Cu/In dont la proportion atomique est entre 1:3 et 1:50, que l'on monte tout d'abord la densité de courant à > 3,5 A/dm² pour former une première couche d'au moins 0,2 µm comprenant > 90 % At d'In, puis que l'on abaisse la densité de courant à < 1,1 A/dm² pour obtenir une deuxième couche ainsi que l'épaisseur totale des deux couches soit de l'ordre de 2 µm avec des proportions atomiques globales Cu/In entre 45 et 55 %.

5. Procédé selon la revendication 1, **caractérisé par le fait que** l'on forme ladite première couche et ladite seconde couche à l'aide d'un même bain galvanique Cu/In dont la proportion At est entre 1:3 et 1:50, dans lequel on disperse environ 200 g/l de poudre de Se de granulométrie < 3 µm, on effectue le dépôt de la première couche en maintenant le substrat fixe en contact avec l'électrolyte, puis on effectue le dépôt de ladite seconde couche en communiquant au substrat un mouvement alternatif horizontalement dans un plan parallèle à celui de l'anode.

6. Procédé selon la revendication 1, **caractérisé par le fait que** l'on forme ladite première couche et ladite seconde couche à l'aide d'un même bain galvanique Cu/In dont la proportion atomique est entre 1:3 et 1:50, dans lequel on disperse environ 200 g/l de poudre de Se de granulométrie < 3 µm, on effectue le dépôt de la première couche en portant la densité de courant à > 5 A/dm² pendant environ 60 s puis on diminue la densité de courant à < 2 A/dm² pendant 1 à 15 min.

7. Procédé selon la revendication 1, **caractérisé par le fait que** l'on dépose l'In et le Cu dans deux bains galvaniques séparés et que l'on incorpore le Se sous forme de particules dans le bain galvanique de l'une au moins desdites couches d'In et de Cu.

8. Procédé selon la revendication 1, **caractérisé par le fait que** ledit substrat conducteur électrique est du Mo, du TiN ou du ZrN déposé par PVD sur une substrat de verre.

9. Procédé selon l'une des revendications 1 et 8, **caractérisé par le fait que** l'on dépose par PVD sur le substrat conducteur électrique une couche de Cu qui représente soit la proportion stoéchiométrique du précurseur du composé CuInSe₂, soit moins que cette proportion, le reste du Cu étant déposé par voie galvanique.

10. Procédé selon l'une des revendications 2 et 7, **caractérisé par le fait que** l'on incorpore entre 10 et 30 g/l de particules de Se dans le bain électrolytique.

11. Procédé selon l'une des revendications 2 et 7, **caractérisé par le fait que** l'on prépare la poudre de Se par un premier broyage à sec avec des billes de céramique et un sel de Na ou K ou un tartrate double (sel de Seignette) suivi d'un second broyage après adjonction de liquide sous forme d'eau ou d'électrolyte et d'un agent dispersant, on lave ensuite la poudre ainsi broyée pour éliminer le sel et obtient des particules < 1 µm.

12. Procédé selon l'un des revendications 2 et 7, **caractérisé par le fait que** l'on met la poudre de Se en suspension dans de l'eau contenant un agent dispersant et on place le tout dans un broyeur à double-cône à billes de céramique de diamètre < 1 mm et on fait tourner le tout à une vitesse de l'ordre de 15 m/s.

13. Procédé selon l'un des revendications 2 et 7, **caractérisé par le fait que** l'on incorpore le Se dans le bain galvanique sous forme de particules colloïdales.

## Claims

1. A method of making a CuInSe₂ compound by depositing a precursor of this compound at least partially electrolytically on a substrate and making the CuInSe₂ compound by thermal reaction, **characterized by** the fact that there is selected an electrically conductive substrate capable of resisting to the reactivity of Se in the vapor phase, on which is deposited a first layer comprising between > 50% and 100% At either of In, or respectively of Cu, the remainder being at least in part either Cu or In respectively, then a second layer having a composition between > 50 % and 100% At either of Cu or respectively In, in order to bring the At ratio In/Cu of the two layers together substantially to 1/1, that between 4% and 100% At of the total In/Cu layer of Se is placed in form of solid particles in contact with at least one of these layers, and that the compound is formed by thermal reaction and bringing, if necessary, the proportion of Se to 100% At of the In/Cu layer by carrying out this thermal reaction in a neutral atmosphere at the vapor pressure of Se.

2. A method according to claim 1, **characterized by** the fact that the Se is incorporated in the second layer in the form of particles mixed in an electrolytic In/Cu bath.

3. A method according to claim 1, **characterized by** the fact that the Se is deposited by a printing process onto the said In/Cu layer.

4. A method according to claim 1, **characterized by** the fact that the first layer and the second layer are formed with the aid of the same Cu/In galvanic bath of which the atomic proportion is between 1:3 and 1:5, that the current density is first increased to > 3.5 A/dm² to form a first layer of at least 0.2µm comprising > 90% At of In, then the current density is lowered to < 1.1 A/dm² to obtain a second layer as well as the overall thickness of two layers in the order of 2µm with overall atomic proportions of Cu/In between 45 and 55%.

5. A method as claimed in claim 1, wherein said first and second layers are formed with the aid of a common Cu/In galvanic bath for which the atomic proportion is between 1:3 and 1:50, and in which there are dispersed approximately 200 g/l of selenium powder having a granulometry of < 3 µm, the deposition of said first layer is carried out while the substrate is maintained fixed in contact with the electrolyte and then the deposition of said second layer is carried out while the substrate is subject to an alternating movement in a plane parallel to that of an anode of said bath.

6. A method as claimed in claim 1, wherein said first and second layers are formed with the aid of a common Cu/In galvanic bath for which the atomic proportion is between 1:3 and 1:50, in which there are dispersed approximately 200 g/l of selenium powder having a granulometry of < 3 µm, and the deposition of said first layer is carried out by bringing the current density > 5 A/dm² for approximately 60 seconds, and then lowering it to < 2 A/dm² for 1 to 15 minutes.

7. A method as claimed in claim 1, wherein In and Cu are deposited in two separate galvanic baths, and the selenium is incorporated in at least one said galvanic bath in the form of particles in at least one of said layers of In and Cu.

8. A method as claimed in claim 1, wherein said electrically conductive substrate is selected from the group consisting of: Mo, TiN, and ZrN ; and is deposited by PVD on a glass substrate.

9. A method as claimed in claim 1 or 8, wherein there is deposited by PVD on the electrically conductive substrate a layer of Cu which represents either the stoichiometric proportion of the precursor of the CuInSe₂ compound, or less than this proportion, the remainder of the Cu being deposited by galvanic means.

10. A method according to claims 2 or 7, wherein between 10 and 30 g/l of particles of Se are incorporated in the electrolytic bath.

11. A method according to claims 2 or 7, wherein the Se powder is prepared by a first dry comminution operation with ceramic balls and a salt of Na or K or a double tartrate (Seignette's salt) followed by a second comminution operation with the addition of liquid in the form of water or electrolyte and a dispersing agent, and the thus comminuted powder is washed to eliminate the salt and obtain particles < 1 µm.

12. A method according to claims 2 or 7, wherein the Se powder is placed in suspension in water containing a dispersing agent and the latter is placed in a double-cone grinder having ceramic balls of diameter < 1mm, and the latter is rotated at a speed in the order of 15 m/s.

13. A method according to claims 2 or 7, wherein the Se is incorporated in the galvanic bath in the form of colloidal particles.

## Patentansprüche

1. Verfahren zur Herstellung einer Verbindung CuInSe₂ durch Abscheidung eines Vorläufers dieser Verbindung auf mindestens teilweise elektrolytischem Wege auf einem Substrat und Bildung der Verbindung CuInSe₂ durch thermische Reaktion, **dadurch gekennzeichnet,**
**dass** man ein elektrisch leitendes Substrat auswählt, das gegenüber der Reaktivität von Se in der Dampfphase (Gasphase) beständig ist, auf dem man abscheidet
eine erste Schicht, die zwischen > 50 und 100 Atom-% In oder Cu enthält, wobei es sich bei dem Rest mindestens zum Teil um Cu bzw. In handelt, und dann
eine zweite Schicht mit einer Zusammensetzung zwischen > 50 und 100 Atom-% Cu bzw. In, um das Atomverhältnis In/Cu der Gesamtheit der beiden Schichten im Wesentlichen auf 1/1 zu bringen,
**dass** man 4 bis 100 Atom-% der gesamten In/Cu-Schicht von Se in Form von Feststoff-Teilchen mit mindestens einer dieser Schichten in Kontakt bringt und
**dass** man die Verbindung bildet durch eine thermische Reaktion, indem man erforderlichenfalls den Mengenanteil von Se auf 100 Atom-% der In/Cu-Schicht bringt, indem man diese thermische Reaktion in einer neutralen Atmosphäre durchführt, die auf den Dampfdruck von Se gebracht worden ist.

2. Verfahren nach Anspruch 1, **dadurch gekennzeichnet, dass** das Se der genannten zweiten Schicht in Form von Teilchen einverleibt wird, die mit dem elektrolytischen In/Cu-Bad gemischt sind.

3. Verfahren nach Anspruch 1, **dadurch gekennzeichnet, dass** das Se durch Anwendung eines Druckverfahrens auf der genannten In/Cu-Schicht abgeschieden wird.

4. Verfahren nach Anspruch 1, **dadurch gekennzeichnet, dass** man die genannte erste Schicht und die genannte zweite Schicht mit Hilfe eines gleichen galvanischen Cu/In-Bades herstellt, in dem das Atomverhältnis zwischen 1 : 3 und 1 : 50 liegt, dass man zunächst die Stromdichte auf > 3,5 A/dm² erhöht zur Bildung einer mindestens 0,2 µm dicken ersten Schicht, die > 90 Atom-% In enthält, dann die Stromdichte auf < 1,1 A/dm² absenkt zur Herstellung einer zweiten Schicht in der Weise, dass die Gesamtdicke der beiden Schichten in der Größenordnung von 2 µm liegt mit Gesamt-Cu/In-Atomverhältnissen zwischen 45 und 55 %.

5. Verfahren nach Anspruch 1, **dadurch gekennzeichnet, dass** man die genannte erste Schicht und die genannte zweite Schicht mit Hilfe eines gleichen galvanischen Cu/In-Bades herstellt, dessen Atomverhältnis zwischen 1 : 3 und 1 : 50 liegt, in dem man etwa 200 g/l Se-Pulver mit einer Teilchengröße von < 3 µm dispergiert, die Abscheidung der ersten Schicht durchführt, indem man das Substrat in einem festen Kontakt mit dem Elektrolyten hält, dann die Abscheidung der genannten zweiten Schicht durchführt, indem man das Substrat einer alternativen horizontalen Bewegung in einer Ebene parallel zu derjenigen der Anode unterwirft.

6. Verfahren nach Anspruch 1, **dadurch gekennzeichnet, dass** man die genannte erste Schicht und die genannte zweite Schicht mit Hilfe eines gleichen galvanischen Cu/In-Bades herstellt, dessen Atomverhältnis zwischen 1 : 3 und 1 : 50 liegt, in dem man etwa 200 g/l Se-Pulver mit einer Teilchengröße von < 3 µm dispergiert, die Abscheidung der ersten Schicht durchführt, indem man die Stromdichte für eine Zeitspanne von etwa 60 s auf einen Wert von > 5 A/dm² bringt und dann die Stromdichte für eine Zeitspanne von 1 bis 15 min auf einen Wert von < 2 A/dm² absenkt.

7. Verfahren nach Anspruch 1, **dadurch gekennzeichnet, dass** man das In und das Cu in zwei getrennten galvanischen Bädern abscheidet und dass man das Se in Form von Teilchen dem galvanischen Bad für mindestens eine der genannten In/Cu-Schichten einverleibt.

8. Verfahren nach Anspruch 1, **dadurch gekennzeichnet, dass** es sich bei dem genannten elektrisch leitenden Substrat um Mo, TiN oder ZrN handelt, das durch PVD auf einem Glassubstrat abgeschieden worden ist.

9. Verfahren nach einem der Ansprüche 1 und 8, **dadurch gekennzeichnet, dass** man auf dem elektrisch leitenden Substrat durch PVD eine Cu-Schicht abscheidet, die entweder den stöchiometrischen Mengenanteil des Vorläufers der Verbindung CuInSe₂ oder weniger als diesen Mengenanteil repräsentiert, wobei der Rest des Cu auf galvanischem Wege abgeschieden wird.

10. Verfahren nach einem der Ansprüche 2 und 7, **dadurch gekennzeichnet, dass** man Se-Teilchen in einer Menge zwischen 10 und 30 g/l dem elektrolytischen Bad einverleibt.

11. Verfahren nach einem der Ansprüche 2 und 7, **dadurch gekennzeichnet, dass** man das Se-Pulver durch ein erstes trockenes Mahlen mit Keramik-Kugeln und einem Na- oder K- oder Tartratdoppelsalz (Seignette-Salz) herstellt und anschließend nach dem Hinzufügen von Flüssigkeit in Form von Wasser oder eines Elektrolyten und eines Dispergiermittels ein zweites Mahlen durchführt, dann das so erhaltene gemahlene Pulver wäscht zum Eliminieren des Salzes, und Teilchen mit einer Teilchengröße von < 1 µm erhält.

12. Verfahren nach einem der Ansprüche 2 und 7, **dadurch gekennzeichnet, dass** man das Se-Pulver in Wasser, das ein Dispergiermittel enthält, suspendiert und das Ganze in eine Doppelkegel-Mahleinrichtung mit Keramikkugeln mit einem Durchmesser von < 1 mm einführt und das Ganze mit einer Geschwindigkeit in der Größenordnung von 15 m/s laufen lässt.

13. Verfahren nach einem der Ansprüche 2 und 7, **dadurch gekennzeichnet, dass** man das Se in Form von kolloidalen Teilchen dem galvanischen Bad einverleibt.
